# EUROPEAN PATENT APPLICATION

(11) **EP 4 224 518 A1**
(43) Date of publication of application: **09.08.2023**
(21) Application number: 21875158.4
(22) Date of filing: 13.09.2021
(51) Int. Cl.: H01L 23/02, H01L 23/12, H01P 5/02, H01P 3/00

(54) **WIRING SUBSTRATE AND ELECTRONIC DEVICE**

(30) Priority: 30.09.2020 JP 2020165212
(71) Applicant: Kyocera Corporation, Kyoto-shi Kyoto 612-8501 (JP)
(72) Inventor: MAEDA, Akihiro, Kyoto-shi, Kyoto 612-8501 (JP); NAKAMOTO, Shinji, Kyoto-shi, Kyoto 612-8501 (JP)
(74) Representative: Viering, Jentschura & Partner mbB Patent- und Rechtsanwälte
(86) International application number: PCT/JP2021/033510
(87) International publication number: WO 2022/070856

(57) **Abstract**

A wiring substrate includes a substrate, a signal conductor, and a ground conductor. The substrate has a first surface and an opening provided in a first surface and being a mounting region for an electronic component. The signal conductor is located on the first surface and extends in a first direction from the opening toward an outer edge of the substrate. The ground conductor is located on the first surface and extends in the first direction, with the signal conductor being sandwiched between portions of the ground conductor. The signal conductor includes a first section, a second section, and a third section arranged in sequence in the first direction. When a dimension of each section in a second direction orthogonal to the first direction in a plan view of the first surface is defined as width, the first section and the third section are each wider than the second section. The ground conductor includes a protrusion extending toward the first section.

## Description

### TECHNICAL FIELD

The present disclosure relates to a wiring substrate and an electronic device.

### BACKGROUND OF INVENTION

A known wiring substrate (e.g., package) forms an electrical connection between an electronic component mounted thereon and external wiring. For example, a coplanar waveguide including ground conductors and a signal conductor disposed between the ground conductors is formed on a surface of the wiring substrate (see, for example, Japanese Unexamined Patent Application Publication No. 2001-94012 and Japanese Unexamined Patent Application Publication No. 2004-186606). Adjusting the shapes of the signal conductor and the ground conductors on the wiring substrate is a conceivable way to provide impedance matching, which in turn improves the efficiency in the transmission of radio-frequency signals through the coplanar waveguide.

### SUMMARY

According to an aspect of the present disclosure, a wiring substrate includes a substrate, a signal conductor, and a ground conductor. The substrate has a first surface and an opening provided in a first surface and being a mounting region for an electronic component. The signal conductor is located on the first surface and extends in a first direction from the opening toward an outer edge of the substrate. The ground conductor is located on the first surface and extends in the first direction, with the signal conductor being sandwiched between portions of the ground conductor. The signal conductor includes a first section, a second section, and a third section arranged in sequence in the first direction. When a dimension of each section in a second direction orthogonal to the first direction in a plan view of the first surface is defined as width, the first section and the third section are each wider than the second section. The ground conductor includes a protrusion extending toward the first section.

According to another aspect of the present disclosure, an electronic device includes the wiring substrate and an electronic component connected to the mounting region.

### BRIEF DESCRIPTION OF THE DRAWINGS

FIG. 1 is a perspective view of an electronic device according to an embodiment.
FIG. 2 is a sectional view of the electronic device taken along line A-A in FIG. 1.
FIG. 3 illustrates a front-surface conductor layer of a wiring substrate.
FIG. 4 is an enlarged view of a signal conductor and a region around it.
FIG. 5 illustrates a first intermediate conductor layer of the wiring substrate.
FIG. 6 illustrates the positional relationship between the signal conductor and an inner ground conductor.
FIG. 7 illustrates the positional relationship between a tapered section of the signal conductor and a second side defining the shape of the inner ground conductor.
FIG. 8 illustrates a second intermediate conductor layer of the wiring substrate.
FIG. 9 illustrates a back-surface conductor layer of the wiring substrate.
FIG. 10 is a sectional view of an electronic device in Variation 1.
FIG. 11 illustrates a front-surface conductor layer of a wiring substrate in Variation 2.

### DESCRIPTION OF EMBODIMENTS

An embodiment will be described below with reference to the accompanying drawings. For convenience, only principal members considered indispensable for describing the embodiment are illustrated in the drawings and are each illustrated in a simplified form. That is, a wiring substrate 100 and an electronic device 1 disclosed herein each may include one or more constituent members that are not illustrated in the drawings. The constituent members illustrated in the drawings are not drawn to scale, and the dimension ratios thereof do not fully correspond to the actual dimension ratios.

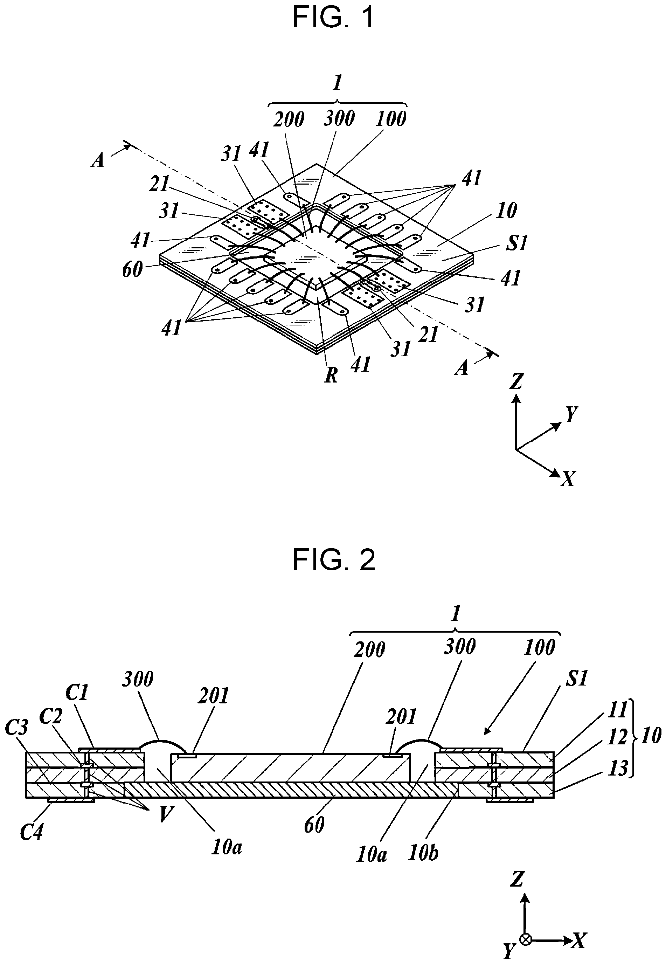

The following describes the configuration of the electronic device 1 according to an embodiment with reference to FIGs. 1 and 2. The electronic device 1 includes the wiring substrate 100 and an electronic component 200, which is mounted on the wiring substrate 100. The electronic device 1 may include bonding wires 300, each of which forms an electrical connection between the wiring substrate 100 and the electronic component 200. For example, the electronic component 200 is a semiconductor device.

The following description about the orientation of each section of the electronic device 1 is based on the XYZ Cartesian coordinate system, where Z denotes the thickness direction of the wiring substrate 100. With regard to each member having surfaces parallel to the XY plane, the surface oriented toward the +Z side is hereinafter referred to as an upper surface, and the surface oriented toward the -Z side is hereinafter referred to as a lower surface. A layer located on the -Z side with respect to another layer is hereinafter referred to as a lower layer. The term "plan view (viewed in plan)" is herein used when a constituent member of interest is viewed in the Z direction, and the term "see-through plan view" is herein used when a constituent member of interest is viewed in the Z direction and seen through.

The wiring substrate 100 includes a substrate 10, signal conductors 21, ground conductors 31, and terminal conductors 41. The substrate 10 is in the form of a rectangular frame when viewed in plan. The signal conductors 21, the ground conductors 31, and the terminal conductor 41 are exposed at an upper surface of the substrate 10. The wiring substrate 100 may include a support base plate 60, which is in the form of a flat plate and is bonded to part of a lower surface of the substrate 10. The bonding wires 300 electrically connect the signal conductors 21, the ground conductors 31, and the terminal conductors 41 to electrode pads 201, which are disposed on a surface of the electronic component 200. The signal conductors 21, the ground conductors 31, and the terminal conductors 41 are hereinafter also collectively referred to as a front-surface conductor layer C1.

The substrate 10 has a first surface S1 (upper surface). The first surface S1 has an opening 10a, which is a mounting region for the electronic component 200. The mounting region is denoted by R. The opening 10a is rectangular when viewed in plan. The opening 10a may have a rectangular shape whose four corners are rounded. It is not required that the opening 10a be rectangular. The opening 10a may have any desired shape ensuring that the mounting region R for the electronic component 200 is provided. The outside shape of the substrate 10 and the shape of the opening 10a each may be defined by one or more sides extending in the X direction and/or one more side extending in the Y direction.

The substrate 10 may include a first layer 11, a second layer 12, and a third layer 13, which are arranged in a stack as illustrated in FIG. 2. The first layer 11 is located on the +Z side with respect to the second layer 12 and the third layer 13. The third layer 13 is located on the -Z side with respect to the first layer 11 and the second layer 12. The substrate 10 may include any desired number of layers. A substrate including three layers will be described below as an example of the substrate 10. The first layer 11 is exposed to view on the +Z side. The first surface S1 is a surface on the +Z side of the first layer 11. The second layer 12 is a core layer between the first layer 11 and the third layer 13. The first layer 11 and the third layer 13 are formed by using sequential build-up technology. More specifically, the first layer 11 and the third layer 13 are build-up layers including prepregs and formed on an upper surface and a lower surface, respectively, of the second layer 12.

The opening 10a is provided in the first layer 11 and the second layer 12. The third layer 13 has a back-surface opening 10b, which is a size larger than the opening 10a when viewed in plan. As with the opening 10a, the back-surface opening 10b may be rectangular when viewed in plan. The back-surface opening 10b may have a rectangular shape whose four corners are rounded. The opening 10a and the back-surface opening 10b extend through the substrate 10 with no members located between them in the Z direction.

The support base plate 60 is substantially identical in shape to the back-surface opening 10b when viewed in plan. The thickness of the support base plate 60 is substantially equal to the thickness of the third layer 13. The back-surface opening 10b is closed with the support base plate 60. The support base plate 60 may be inserted into the back-surface opening 10b from the side on which the lower surface of the substrate 10 is located. That is, the support base plate 60 fitted in the back-surface opening 10b may be bonded to the substrate 10. In some embodiments, the surface area of the support base plate 60 is greater than the back-surface opening 10b, in which case the support base plate 60 may be bonded to a lower surface of the third layer 13. The support base plate 60 is in contact with part of the lower surface of the second layer 12. When viewed in plan from the -Z side, the part of the lower surface is exposed at the back-surface opening 10b with the support base plate 60 seen through. The electronic component 200 is placed on and connected (fixed) to part of an upper surface of the support base plate 60. The part of the support base plate 60 corresponds to the mounting region R. That is, the part of the support base plate 60 is located in the opening 10a when viewed in plan from the +Z side. The support base plate 60 serves as a heat-dissipating plate; that is, heat generated by the electronic component 200 in operation is radiated to the outside through the support base plate 60. To that end, the support base plate 60 may be made of a highly thermally conductive material. For example, the support base plate 60 is made of copper or an alloy of copper and tungsten (CuW).

The support base plate 60 may include two layers. For example, one of the layers is fitted in the back-surface opening 10b and is bonded to the lower surface of the second layer 12. The other layer, whose surface area is smaller than that of the aforementioned layer, is fitted in part of the opening 10a.

The substrate 10 also includes conductor layers other than the front-surface conductor layer C1. A conductor layer on the upper surface of the second layer 12 is hereinafter referred to as a first intermediate conductor layer C2. A conductor layer on the lower surface of the second layer 12 is hereinafter referred to as a second intermediate conductor layer C3. A conductor layer on the lower surface of the third layer 13 is hereinafter referred to as a back-surface conductor layer C4. The front-surface conductor layer C1 is electrically connected to the first intermediate conductor layer C2 with via conductors V therebetween. The first intermediate conductor layer C2 is electrically connected to the second intermediate conductor layer C3 with the via conductors V therebetween. The second intermediate conductor layer C3 is electrically connected to the back-surface conductor layer C4 with the via conductors V therebetween. The back-surface conductor layer C4 is connected to external wiring with a solder ball therebetween. Thus, the bonding wires 300, the front-surface conductor layer C 1, the first intermediate conductor layer C2, the second intermediate conductor layer C3, and the back-surface conductor layer C4 electrically connect the electrode pads 201 of the electronic component 200 to the external wiring.

The material of the substrate 10 may contain resin. Examples of the resin include epoxy resin, bismaleimide-triazine resin, polyimide resin, and polyphenylene ether (PPE) resin. A reinforcing material, such as glass cloth or aramid cloth may be added to the resin.

It is not required resin be contained in the material of the substrate 10 and the support base plate 60. For example, the substrate 10 and the support base plate 60 are made of a sintered ceramic material, such as sintered aluminum oxide, sintered aluminum nitride, sintered silicon carbide, sintered mullite, or glass ceramics. Using a resinous material to form the substrate 10 and the support base plate 60 of the wiring substrate 100 offers the following advantages: the cost of production may be lower than if the wiring substrate is made of a sintered ceramic material; and the wiring substrate 100 exhibits excellent radio-frequency characteristics.

The front-surface conductor layer C1, the first intermediate conductor layer C2, the second intermediate conductor layer C3, and the back-surface conductor layer C4 may be made of a desired material and may, for example, each be a copper pattern plated with gold or nickel. The first intermediate conductor layer C2 and the second intermediate conductor layer C3 are not exposed to view from the outside and may therefore each be a copper pattern not covered with another metal.

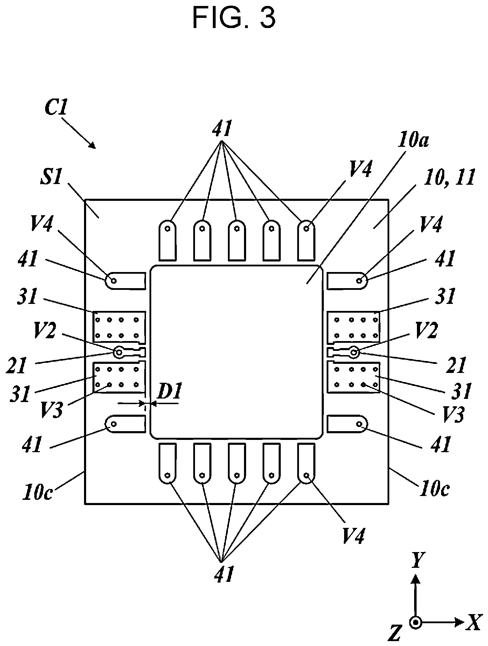

The front-surface conductor layer C1, the first intermediate conductor layer C2, the second intermediate conductor layer C3, and the back-surface conductor layer C4 will be described below with reference to FIGs. 3 to 9.

FIG. 3 illustrates the first surface S1 of the first layer 11 viewed from the +Z side. The front-surface conductor layer C1 is exposed at the first surface S1 of the first layer 11. The front-surface conductor layer C1 includes two signal conductors denoted by 21. The signal conductors 21 are located on opposite sides with the opening 10a therebetween in the X direction. The signal conductors 21 are formed on a substantially middle part of the substrate 10 (the first layer 11) in the Y direction. The signal conductors 21 extend in a first direction from the opening 10a toward an outer edge 10c of the substrate 10. One of the signal conductors 21 extending in the first direction is located on the +X side with respect to the opening 10a and may thus be regarded as extending in the +X direction, and the other signal conductor 21 is located on the -X side with respect to the opening 10a and may thus be regarded as extending in the -X direction. The signal conductors 21 are connected with via conductors V2. Each of the via conductors V2 may be a cylindrical conductor extending through the first layer 11, the second layer 12, and the third layer 13 or may be composed of conductors each having a shape of part of a cone and connected to each other in the Z direction. Each of the via conductors V2 may be located on one side of the corresponding one of the signal conductors 21, where the one side may be closer than the opposite side of the signal conductor 21 to the outer edge 10c. The same holds for via conductors V3 and via conductors V4, which will be described later.

The front-surface conductor layer C1 includes four ground conductors denoted by 31. The ground conductors 31 are located on opposite sides with the opening 10a therebetween in the X direction. More specifically, two of the four ground conductors 31 are located on one side in the X direction, and the other two ground conductors 31 are located on the other side in the X direction. Each of the signal conductors 21 is sandwiched between the ground conductor 31 on the +Y side and the ground conductor 31 on the -Y side. In other words, each ground conductor 31 extends in the first direction, with the signal conductor 21 being sandwiched between portions of the ground conductor 31. When viewed from another perspective, each of the signal conductors 21 is located between one ground conductor 31 on the +Y side and another ground conductor 31 on the -Y side. The ground conductors 31 each have a rectangular shape extending in the X direction. The ground conductors 31 are placed at the ground potential. The ground conductors 31 are connected with via conductors denoted by V3.

Two ground conductors 31 and one signal conductor 21 sandwiched between the two ground conductors 31 constitute a coplanar waveguide through which radio-frequency signals can be transmitted. For example, radio-frequency signals at a frequency of about 60 GHz are transmitted through the coplanar waveguide of the wiring substrate 100 according to the present embodiment. In some embodiments, signals of other frequencies are transmitted through the coplanar waveguide.

Referring to FIG. 3, the front-surface conductor layer C1 may include fourteen terminal conductors denoted by 41. The terminal conductors 41 located on the +Y side with respect to the opening 10a may be equally spaced. Likewise, the terminal conductors 41 located on the -Y side with respect to the opening 10a may be equally spaced. The two ground conductors 31 located on the +X side with respect to the opening 10a may be sandwiched between two terminal conductors 41 located on the +Y side and -Y side, respectively, with respect to the two ground conductors 31. Likewise, the two ground conductors 31 located on the -X side with respect to the opening 10a may be sandwiched between two terminal conductors 41 located on the +Y side and -Y side, respectively, with respect to the two ground conductors 31. The terminal conductors 41 may be connected with the respective via conductors V4. Each of the via conductors V4 may be connected to an end portion closer than the other end portion of the corresponding one of the terminal conductors 41 to the outer edge 10c.

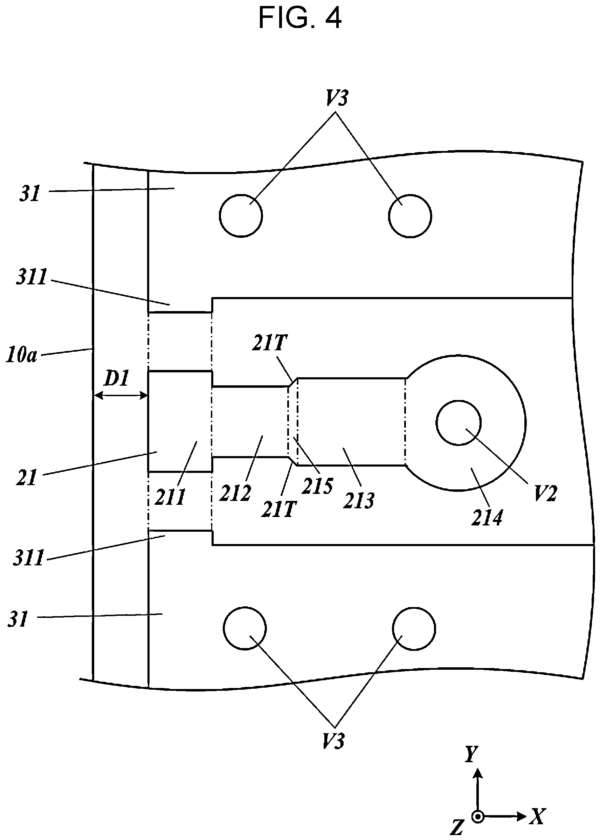

The shape of the signal conductors 21 and the shape of the ground conductors 31 will be described in detail below with reference to FIG. 4.

The signal conductors 21 and the ground conductors 31 are arranged at a distance from the opening 10a when viewed in plan. To be more specific, the signal conductors 21 and the ground conductors 31 each have an edge that is closer than their other edges to the opening 10a and that is located at a distance D1 from the opening 10a when viewed in plan. In other words, the signal conductors 21 and the ground conductors 31 are arranged with a pullback (clearance) between the opening 10a and each of these conductors. The pullback corresponds to the distance D1. For example, the distance D1 may be in a range of 0.05 to 0.3 mm. With the pullback provided as above, the opening 10a is kept from overlapping the signal conductors 21 and the ground conductors 31 when being formed. If the opening 10a overlaps the signal conductors 21 and the ground conductors 31 each being in the form of a copper pattern plated with another metal, the plating on the copper pattern would come off in places, in which case the copper pattern would be exposed at a side surface (i.e., an inner wall surface defining the opening 10a) and would, in turn, be oxidized. Providing the pullback reduces the possibility that the copper pattern will be exposed at the surface of the wiring substrate 100.

The signal conductors 21 each include a first section 211, a second section 212, a third section 213, and a fourth section 214, which are arranged in sequence in the first direction (from the -X side to the +X side in FIG. 4). When the dimension of each section in a second direction (Y direction) orthogonal to the first direction in a plan view of the first surface S1 is defined as the width, the first section 211 and the third section 213 are each wider than the second section 212. That is, with the second section 212 being located between the first section 211 and the third section 213 of the signal conductor 21, the dimension of the second section 212 in the Y direction is smaller than the width of the first section 211 and the width of the third section 213. The first section 211 includes an end portion closer than the other end portion of the signal conductor 21 to the opening 10a. The first section 211 is connected with the bonding wire 300. The first section 211, the second section 212, and the third section 213 each may have a rectangular shape having sides extending in the X direction. The fourth section 214 is an end portion farther than the other end portion of the signal conductor 21 from the opening 10a. When viewed in plan, the fourth section 214 may be circular and encircle the via conductor V2.

The signal conductors 21 each include a tapered section 215, which is located between the second section 212 and the third section 213. The tapered section 215 has taper sides 21T, which are straight lines inclined with respect to the X direction and the Y direction. The taper sides 21T extend obliquely to connect a side defining the second section 212 to a side defining the third section 213, where the second section 212 and the third section 213 have dimensional differences in the Y direction. In other words, the second section 212 and an end portion being part of the tapered section 215 and closer to the second section 212 have the same dimension (width) in the Y direction, and the third section 213 and another end portion being part of the tapered section 215 and closer to the third section 213 have the same dimension (width) in the Y direction. The portion between the end portions gradually increases in width with increasing distance from the second section 212.

The ground conductors 31 each include a protrusion 311. The protrusion 311 of each ground conductor 31 is part of an end portion closer than the other end portion of the ground conductor 31 to the opening 10a and extends toward the first section 211. The protrusion 311 and the first section 211 may have the same dimension (length) in the X direction. That is, the first section 211 of each signal conductor 21 and the protrusion 311 of the corresponding ground conductor 31 may be located within the same boundaries in the X direction. An end portion closer than the other end portion of each ground conductor 31 to the opening 10a or, more specifically, a portion including a region in which the protrusion 311 extends in the X direction is connected with the bonding wire 300.

With the signal conductors 21 and the ground conductors 31 having the aforementioned shapes, the impedance of the coplanar waveguide of the wiring substrate 100 is set to a desired value for impedance matching. This will be elaborated below.

Providing the pullback, that is, arranging the signal conductors 21 and the ground conductors 31 at the distance D1 from the opening 10a yields an increase in the length of each bonding wire 300, which is extended by the distance D1 in the present embodiment compared with a case in which the conductors extend to the edges of the opening 10a. This leads to increased inductance components and in turn to high impedance. For this reason, if the signal conductors 21 and the ground conductors 31 are each designed as a conductor of constant width, it would be difficult to control the impedance.

This problem is addressed by the present embodiment, in which each ground conductor 31 including the protrusion 311 is closer to the first section 211 of the signal conductor 21. The capacitance of part of the coplanar waveguide is increased accordingly. To be more specific, the capacitance of a portion extending in the X direction and corresponding to the first section 211 and the protrusion 311 is increased and is thus regarded as a high-capacitance portion. The influence of the increased reactance components caused by the increase in the length of each bonding wire 300 is reduced due to the capacitive reactance of the high-capacitance portion. The first section 211 and the protrusion 311 in the present embodiment are located within the same located boundaries in the X direction. Accordingly, the impedance can be controlled with greater accuracy.

The section located on the +X side with respect to the first section 211, namely, the second section 212 is narrower than the first section 211. The inductance of part of the coplanar waveguide is increased accordingly. To be more specific, the capacitance of a portion extending in the X direction and corresponding to the second section 212 is increased and is thus regarded as a high-inductance portion. The influence of the capacitive reactance of the high-capacitance portion is readjusted due to inductive reactance of the high-inductance portion. In this way, a desired impedance level is achieved in the third section 213, which is next to the high-inductance portion. The ground conductors 31 each do not include a protrusion extending toward the third section 213. The distance between the third section 213 and the ground conductor 31 is greater than the distance between the first section 211 and the ground conductor 31 (the protrusion 311). In this way, adjustments are made to avoid excessive capacitance being a cause of impedance reduction in the third section 213, that is, to avoid an increase in signal reflection.

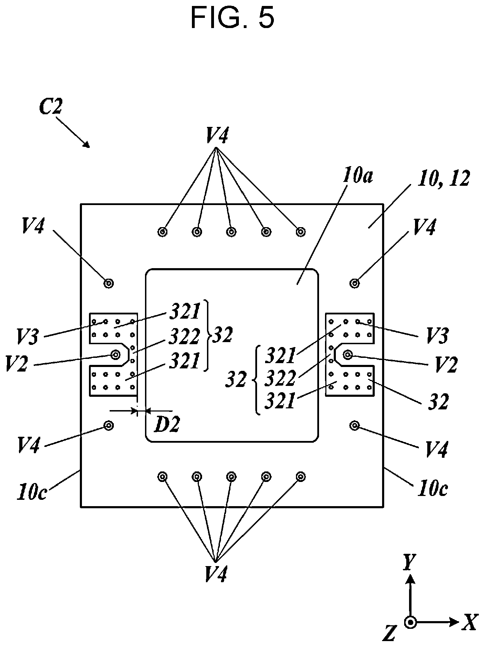

The first intermediate conductor layer C2 will be described below with reference to FIG. 5. FIG. 5 is a see-through plan view of the second layer 12, illustrating the upper surface of the second layer 12 viewed from the +Z side.

The first intermediate conductor layer C2 includes lands for the two via conductors V2 for connection to the respective signal conductors 21 and lands for the fourteen via conductors V4 for connection to the respective terminal conductors 41. The first intermediate conductor layer C2 includes two inner ground conductors each extending around the land provided for the corresponding one of the two via conductors V2. The inner ground conductors are hereinafter also referred to as first inner ground conductors 32.

The first inner ground conductor 32 includes two rectangular sections 321, which overlap the respective ground conductors 31 in a see-through plan view. The first inner ground conductors 32 each may include a connection section 322, which connects the two rectangular sections 321 to each other. The connection section 322 extends in the Y direction (the second direction) and forms a connection between end portions of the rectangular sections 321 on the side closer than the other side to the opening 10a. The rectangular sections 321 and the connection section 322 are formed at a predetermined distance (with a clearance) from the land provided for the via conductor V2. The first inner ground conductor 32 may include a connection section that forms a connection between end portions of the rectangular sections 321 on the side farther than the other side from the opening 10a. The land provided for the via conductor V2 may be encircled by the first inner ground conductor 32.

The first inner ground conductors 32 are electrically connected to the ground conductors 31 with the via conductors V3 therebetween and are also electrically connected to a second inner ground conductor 33 and a back-surface ground conductor 34, which will be described later. Accordingly, the first inner ground conductors 32 are placed at the ground potential. That is, each of the first inner ground conductors 32 and each of the ground conductor 31 are at the same potential, or each of the first inner ground conductors 32 and each of the second inner ground conductor 33 are at the same potential. These features provide stable ground potential. The connection section 322 of each of the first inner ground conductor 32 forms a connection between the two rectangular sections 321. This feature enables a further improvement in the stability of the ground potential.

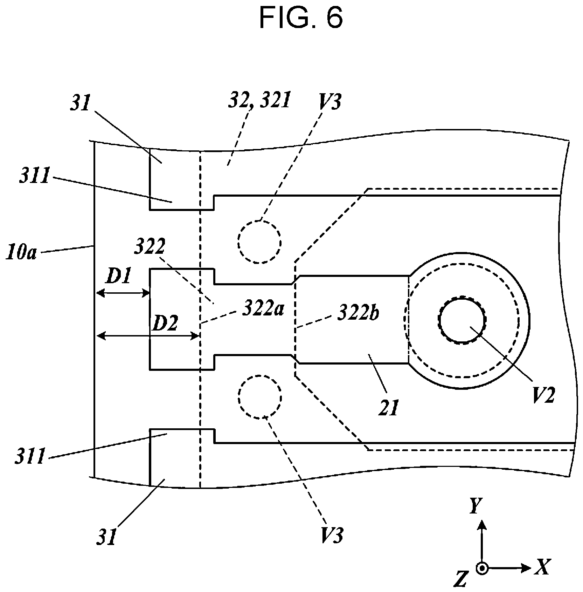

The following describes the positional relationship between each of the signal conductors 21 in the front-surface conductor layer C1 and each of the first inner ground conductors 32 in the first intermediate conductor layer C2, with reference to FIG. 6. The signal conductor 21 and the ground conductors 31 in FIG. 6 are each drawn with a solid line. The first inner ground conductor 32 viewed in plan from the +Z side in FIG. 6 is drawn with a broken line denoting that the first inner ground conductor 32 is seen through.

The connection section 322 of the first inner ground conductor 32 has a shape defined by a first side 322a and a second side 322b, which are lines extending side by side in the first direction. With the connection section 322 having two sides (outlines) extending in the Y direction, one side closer than the other side to the opening 10a is the first side 322a, and the other side farther from the opening 10a is the second side 322b.

The first inner ground conductor 32 is located at a distance from the opening 10a when viewed in plan. To be more specific, an edge (including the first side 322a and) being closer than other edges of the first inner ground conductor 32 to the opening 10a is located at a distance D2 from the opening 10a when viewed in plan. In other words, a pullback corresponding to the distance D2 is provided between the opening 10a and the first inner ground conductor 32. The reason why the pullback is provided for the first inner ground conductors 32 may be understood as analogous to the aforementioned reason for providing a pullback for the signal conductors 21 and the ground conductors 31.

The distance D2 may be greater than the distance D1. For example, the distance D2 may be in a range of 0.1 to 0.5 mm. The reason for this is as follows.

The first inner ground conductors 32 are embedded in the substrate 10. That is, it is not possible to visually locate the first inner ground conductors 32 when the opening 10a is formed in the substrate 10. If there is a misalignment associated with the first inner ground conductors 32 formed with a pullback equal to the distance D1 (e.g., the pullback provided for each of the signal conductors 21) before the opening 10a is formed, the opening 10a would possibly overlap the first inner ground conductors 32. If the opening 10a overlaps the first inner ground conductors 32, the plating on the copper pattern would come off in places, in which case the copper pattern would be exposed and would, in turn, be oxidized.

This problem is addressed by the present embodiment, in which the distance D2, namely, the pullback provided for each of the first inner ground conductors 32 is greater than the distance D1. This feature eliminates or reduces the possibility that the opening 10a will overlap the first inner ground conductors 32 whose distance from the planned site of the opening 10a is not as long as it ought to be due to, for example, misalignment of any of the layers of the wiring substrate 100 during manufacturing.

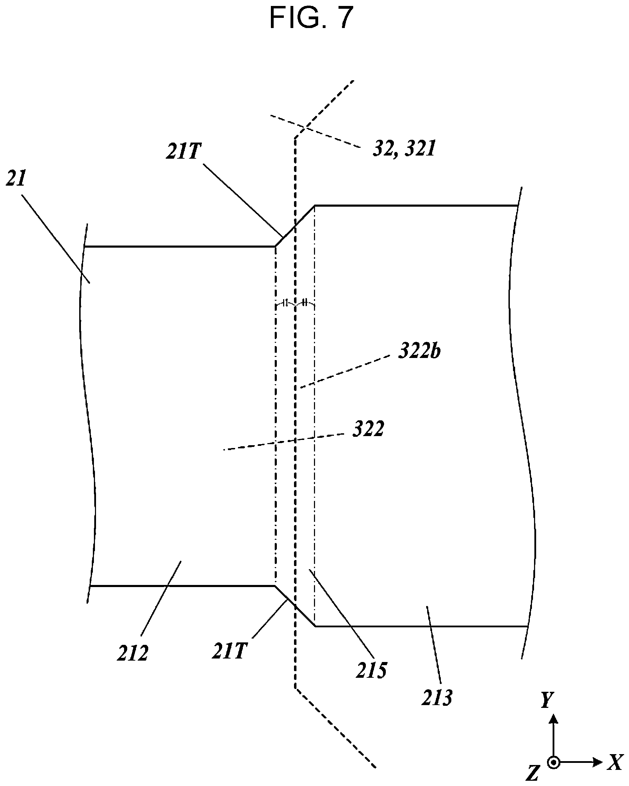

The connection section 322 in a see-through plan view (see FIG. 6) crosses the signal conductor 21, with their intersection being an overlap between the connection section 322 and the second section 212 of the signal conductor 21. To be more specific, the second side 322b of the connection section 322 in a see-through plan view (see FIG. 7) overlaps the tapered section 215 of the signal conductor 21. When the second side 322b in a see-through plan view overlaps the tapered section 215, the second side 322b in the see-through plan view may overlap the middle part of the tapered section 215 in the X direction in the see-through plan view.

The impedance of the coplanar waveguide varies with the area of the overlap between the connection section 322 and the signal conductor 21. While the conductor layers are formed, the positional relationship between the connection section 322 and the signal conductor 21 can vary due to, for example, misalignment of the constituent elements. If the second section 212 and the third section 213 are located side by side without the tapered section 215 therebetween; that is, if the width of the connection portion therebetween does not change incrementally, the area of the overlap between the connection section 322 and the signal conductor 21 varies depending on whether the second side 322b of the connection section 322 passes through the second section 212 or the third section 213.

Owing to the aforementioned feature of the wiring substrate 100, that is, with the second side 322b overlapping the middle part of the tapered section 215, the impedance does not vary widely when the connection section 322 and the signal conductor 21 are displaced with respect to each other either in the +X direction or in the -X direction.

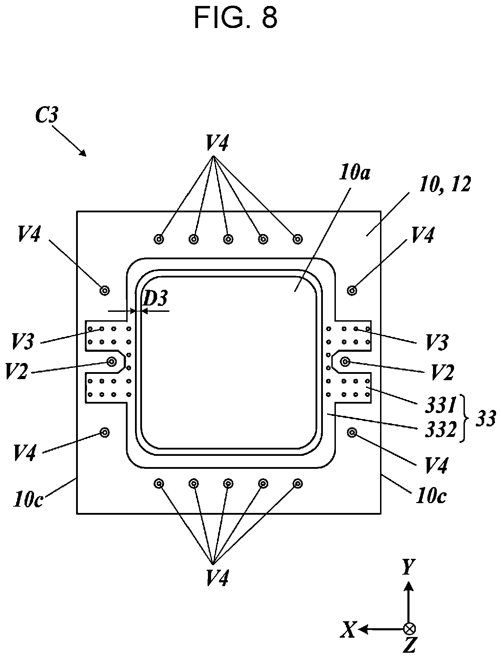

The second intermediate conductor layer C3 will be described below with reference to FIG. 8. FIG. 8 is a see-through plan view of the second layer 12, illustrating the lower surface of the second layer 12 viewed from the -Z side.

The second intermediate conductor layer C3 includes lands for the two via conductors V2 and lands for the fourteen via conductors V4. The second intermediate conductor layer C3 also includes the second inner ground conductor 33, which encircles the opening 10a with no gap between one part and another part of the second inner ground conductor 33.

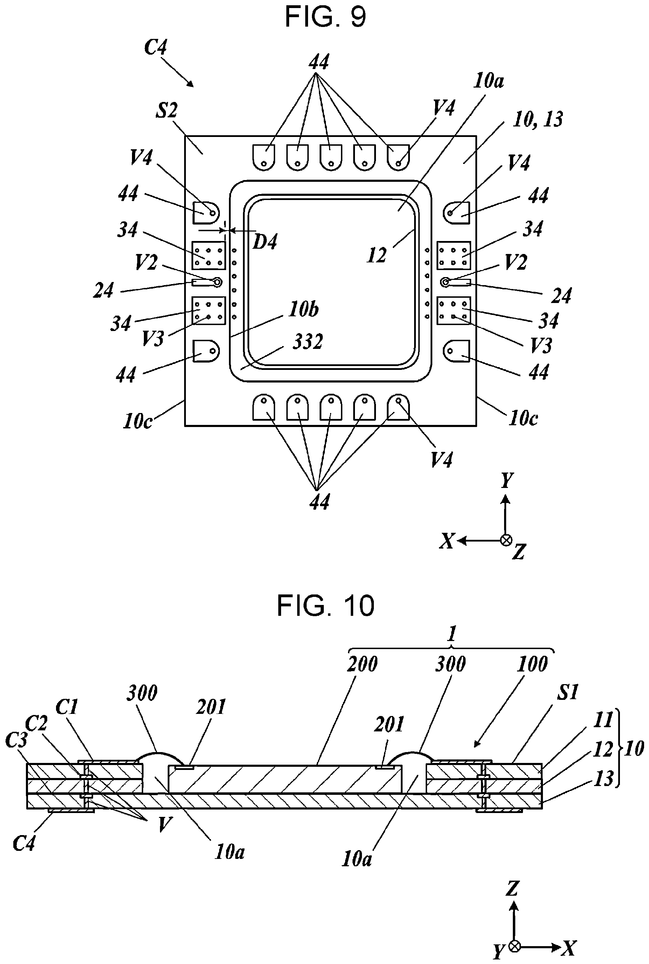

The second inner ground conductor 33 includes four rectangular sections 331 and a frame section 332. In a see-through plan view, each of the four rectangular sections 331 overlaps the corresponding one of the rectangular sections 321 of the first inner ground conductor 32 included in the first intermediate conductor layer C2. The four rectangular sections 331 are connected to each other by the frame section 332, which extends around the opening 10a. The frame section 332 is exposed at the back-surface opening 10b when viewed in plan from the -Z side. In other words, the frame section 332 is located within a region having the shape of a frame and surrounded with an inner wall surface of the back-surface opening 10b and the inner wall surface of the opening 10a when viewed in plan from the -Z side (see FIG. 9). The frame section 332 is in contact with the support base plate 60 fitted in the back-surface opening 10b and is electrically connected to the support base plate 60. The support base plate 60 is placed at the ground potential accordingly.

The frame section 332 is located at a distance from the opening 10a when viewed in plan. To be more specific, a pullback corresponding to a distance D3 is provided between the opening 10a and the frame section 332. For example, the distance D3 may be in a range of 0.1 to 0.5 mm.

The back-surface conductor layer C4 will be described below with reference to FIG. 9. FIG. 9 is a see-through plan view of the substrate 10, illustrating the lower surface of the substrate 10 viewed from the -Z side. The back-surface conductor layer C4 on the lower surface of the third layer 13 and the frame section 332 included in the second intermediate conductor layer C3 and exposed at the back-surface opening 10b of the third layer 13 are illustrated in FIG. 9. The back-surface conductor layer C4 includes two back-surface signal conductors 24, four back-surface ground conductors 34, and fourteen back-surface terminal conductors 44.

The back-surface signal conductors 24 are electrically connected to the signal conductors 21 with the via conductors V2 therebetween. Each back-surface signal conductor 24 extends from the joint between the corresponding signal conductor 21 and the corresponding via conductor V2 toward the outer edge 10c.

The back-surface ground conductors 34 are electrically connected to the ground conductors 31, the first inner ground conductors 32, and the second inner ground conductor 33 with the via conductors V3 therebetween. Each back-surface ground conductor 34 in the see-through plan view has a rectangular shape and extends over part of the corresponding ground conductor 31, part of the corresponding ones of the rectangular sections 321 of the first inner ground conductors 32, and part of the corresponding one of the rectangular sections 331 of the second inner ground conductors 33. The back-surface ground conductors 34 are located at a distance from the back-surface opening 10b when viewed in plan. A pullback corresponding to a distance D4 is provided between the back-surface opening 10b and each of the back-surface ground conductors 34. For example, the distance D4 may be in a range of 0.05 to 0.3 mm.

The back-surface terminal conductors 44 are electrically connected to the terminal conductors 41 with the via conductors V4 therebetween. Each back-surface terminal conductor 44 extends from the joint between the back-surface terminal conductor 44 and the corresponding via conductor V4 toward the outer edge 10c.

The following describes an example procedure for producing the wiring substrate 100 designed as above.

First, a core layer is obtained as follows: the first intermediate conductor layer C2 and the second intermediate conductor layer C3 are formed on the front and back, respectively, of a resin base provided as the second layer 12, and a conductor layer (part of the via conductors V) extending through the resin base is also formed.

Then, a multilayer body is obtained as follows: a prepreg provided as the first layer 11 and copper foil provided as part of the front-surface conductor layer C1 are laid on an upper surface of the core layer, and a prepreg provided as the third layer 13 and copper foil provided as part of the back-surface conductor layer C4 are laid on a lower surface of the core layer. The prepregs are obtained by semi-curing a reinforcing material (e.g., glass cloth) impregnated with resin.

The multilayer body is then heated and pressed in its thickness direction to harden the prepregs.

Then, pilot holes extending through the hardened prepregs and copper foil are formed in the planned site of the via conductors V with a drill or beams of laser light, and a plating layer for forming part of the via conductors V, the front-surface conductor layer C1, and the back-surface conductor layer C4 is obtained by electrolytic panel plating.

Subsequently, the plating layer is partially removed by a subtractive process to form patterns of the front-surface conductor layer C1 and the back-surface conductor layer C4.

The third layer 13 may be partially removed by laser machining to form the back-surface opening 10b in the third layer 13. The back-surface opening 10b in the third layer 13 may thus have a shape different from the shape of the opening 10a formed in the first layer 11 and the second layer 12. The first layer 11 and the second layer 12 are then partially cut away with a router to form the opening 10a. Owing to the pullbacks provided for the front-surface conductor layer C1, the first intermediate conductor layer C2, the second intermediate conductor layer C3, and the back-surface conductor layer C4, the opening 10a and the back-surface opening 10b may be formed with no overlap with these layers.

The support base plate 60 is then fitted into the back-surface opening 10b. The wiring substrate 100 obtained by this process is in finished form.

If holes are drilled with a router in some way before the plating layer is formed, the plating layer formed thereafter would extend over the inner wall surface of the opening 10a and the inner wall surface of the back-surface opening 10b. In this case, an additional step of removing the plating layer from the inner walls is necessary. The present embodiment obviates the need for the additional step, and the wiring substrate 100 can thus be produced in a simpler manner.

### (Variation 1)

The following describes Variation 1 of the embodiment with reference to FIG. 10.

Variation 1 concerns an example in which the back-surface opening 10b is not provided in the third layer 13. The electronic component 200 is connected directly to the upper surface of the third layer 13. This means that the third layer 13 serves as the support base plate 60 in the embodiment described above.

This feature of the wiring substrate 100 eliminates the need for the step of forming the back-surface opening 10b in the third layer 13 and thus simplifies the process of producing the wiring substrate 100. Obviating the need for preparing the support base plate 60 translates into a reduction in the number of constituent components of the wiring substrate 100.

### (Variation 2)

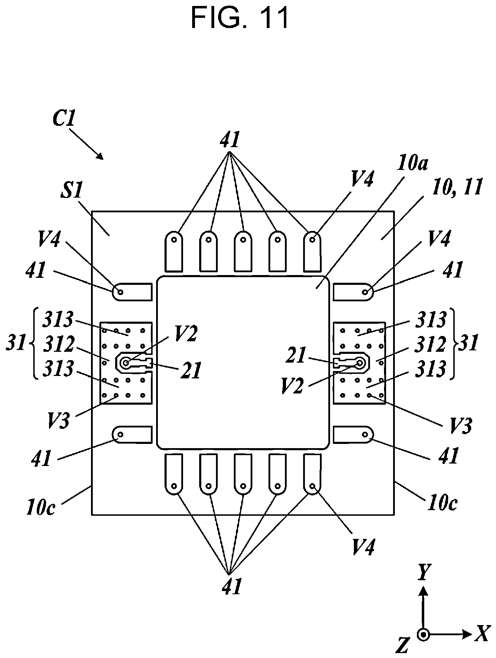

The following describes Variation 2 of the embodiment with reference to FIG. 11. The Variations 1 and 2 may be employed in combination.

Variation 2 concerns an example in which the ground conductors 31 in the front-surface conductor layer C1 each include two rectangular sections 313 and a connection section 312. The two rectangular sections 313 are located on the +Y side and the -Y side with respect to the signal conductor 21 and are connected to each other by the connection section 312. The connection section 312 extends in the Y direction (the second direction) and forms a connection between end portions of the rectangular sections 313 on the side closer than the other side to the outer edge 10c. That is, the two rectangular sections 313 are connected to each other by the connection section 312. This feature enables a further improvement in the stability of the ground potential.

The embodiment above is presented as an example, and various changes may be made to the embodiment.

For example, the embodiment above concerns an example in which the substrate 10 is a multilayer body including three layers (the first layer 11, the second layer 12, and the third layer 13). In some embodiments, however, the substrate 10 is a multilayer body including two layers or a multilayer body including four or more layers. With more layers arranged in a stack, more conductor layers may be laid between them, in which case the impedance can be adjusted in a more appropriate manner. The interlayers placed between the increased number of layers may be structurally identical to the first intermediate conductor layer C2. It is not required that the substrate 10 be a multilayer structure.

The signal conductors 21 may each include a tapered section between the first section 211 and the second section 212.

The signal conductors 21 and/or the ground conductors 31 each may extend to an edge of the opening 10a. The signal conductors 21 and the ground conductors 31 may be geometrically identical to the respective conductors in the embodiment above.

The details (e.g., features, structures, positional relationships, and shapes) described above in relation to the embodiment may be changed as appropriate within a range not departing from the spirit of the disclosure. The features, structures, positional relationships, and shapes described above in relation to the embodiment may be employed in combination as appropriate within a range not departing from the spirit of the disclosure.

### INDUSTRIAL APPLICABILITY

The present disclosure is applicable to a wiring substrate and an electronic device.

### REFERENCE SIGNS

- 1: electronic device
- 10: substrate
- 10a: opening
- 10b: back-surface opening
- 10c: outer edge
- 21: signal conductor
- 211: first section
- 212: second section
- 213: third section
- 214: fourth section
- 215: tapered section
- 21T: taper side
- 24: back-surface signal conductor
- 31: ground conductor
- 311: protrusion
- 312: connection section
- 313: rectangular section
- 32: first inner ground conductor (inner ground conductor)
- 321: rectangular section
- 322: connection section
- 322a: first side
- 322b: second side
- 33: second inner ground conductor
- 331: rectangular section
- 332: frame section
- 34: back-surface ground conductor
- 41: terminal conductor
- 44: back-surface terminal conductor
- 60: support base plate
- 100: wiring substrate
- 200: electronic component
- 201: electrode pad
- 300: bonding wire
- C1: front-surface conductor layer
- C2: first intermediate conductor layer
- C3: second intermediate conductor layer
- C4: back-surface conductor layer
- R: mounting region
- V, V2 to V4: via conductors

## Claims

1. A wiring substrate comprising:
a substrate;
a signal conductor;
a ground conductor, wherein
the substrate comprises a first surface and an opening provided in a first surface and being a mounting region for an electronic component,
the signal conductor is located on the first surface and extends in a first direction from the opening toward an outer edge of the substrate,
the ground conductor is located on the first surface and extends in the first direction, with the signal conductor being sandwiched between portions of the ground conductor,
the signal conductor comprises a first section, a second section, and a third section arranged in sequence in the first direction,
when a dimension of each section in a second direction orthogonal to the first direction in a plan view of the first surface is defined as width, the first section and the third section are each wider than the second section, and
the ground conductor comprises a protrusion extending toward the first section.

2. The wiring substrate according to claim 1, wherein the signal conductor comprises a tapered section between the second section and the third section.

3. The wiring substrate according to claim 1 or 2, wherein the protrusion is equal in length to the first section in the first direction.

4. The wiring substrate according to claim 2, wherein
the substrate comprises an inner ground conductor,
the inner ground conductor and the ground conductor are placed at same potential,
the inner ground conductor comprises a section extending in the second direction in a see-through plan view of the first surface,
the section has a shape defined by a first side and a second side extending side by side in the first direction, and
the second side and the tapered section overlap each other in the see-through plan view.

5. The wiring substrate according to claim 4, wherein the second side and a middle part of the tapered section in the first direction overlap each other in the see-through plan view.

6. The wiring substrate according to any one of claims 1 to 5, wherein the ground conductor and the signal conductor in a see-through plan view are located at a distance from the opening.

7. The wiring substrate according to claim 4 or 5, wherein
the ground conductor and the signal conductor in the see-through plan view are each located at a distance D1 from the opening,
the first side in the see-through plan view is located at a distance D2 from the opening, and
the distance D2 is greater than the distance D1.

8. The wiring substrate according to any one of clams 1 to 7, wherein the substrate comprises a resinous material.

9. An electronic device comprising:
the wiring substrate according to any one of claims 1 to 8; and
an electronic component connected to the mounting region.
